# EUROPEAN PATENT SPECIFICATION

(11) **EP 3 201 953 B1**
(45) Date of publication and mention of the grant of the patent: **07.08.2019**
(21) Application number: 15777841.6
(22) Date of filing: 29.09.2015
(51) Int. Cl.: F21K 9/64, F21Y 115/10, F21Y 113/13, F21Y 113/17, H01L 33/50, H01L 25/075, H05B 33/08

(54) **LIGHT SOURCE WITH TUNABLE EMISSION SPECTRUM**
LICHTQUELLE MIT ABSTIMMBAREM EMISSIONSSPEKTRUM
SOURCE LUMINEUSE À SPECTRE D'ÉMISSION ACCORDABLE

(30) Priority: 01.10.2014 US 201462058162 P
(43) Date of publication of application: 09.08.2017
(73) Proprietor: Lumileds Holding B.V., 1118 CL Schiphol (NL)
(72) Inventor: SHCHEKIN, Oleg Borisovich, San Jose, California 95131 (US); CHOI, Han-Ho, San Jose, California 95131 (US); VAMPOLA, Kenneth, San Jose, California 95131 (US); JIN, Fahong, San Jose, California 95131 (US)
(74) Representative: ter Heegde, Paul Gerard Michel
(86) International application number: PCT/US2015/053005
(87) International publication number: WO 2016/054082

(56) References cited:
- DE-A1-102012 101 412
- US-A1- 2013 020 929

## Description

### Field of the invention

The present invention relates to a light source with emission spectrum that can be tuned.

### Background

Semiconductor light-emitting devices including light emitting diodes (LEDs), resonant cavity light emitting diodes (RCLEDs), vertical cavity laser diodes (VCSELs), and edge emitting lasers are among the most efficient light sources currently available. Materials systems currently of interest in the manufacture of high-brightness light emitting devices capable of operation across the visible spectrum include Group III-V semiconductors, particularly binary, ternary, and quaternary alloys of gallium, aluminum, indium, and nitrogen, also referred to as III-nitride materials. Typically, III-nitride light emitting devices are fabricated by epitaxially growing a stack of semiconductor layers of different compositions and dopant concentrations on a sapphire, silicon carbide, III-nitride, or other suitable substrate by metal-organic chemical vapor deposition (MOCVD), molecular beam epitaxy (MBE), or other epitaxial techniques. The stack often includes one or more n-type layers doped with, for example, Si, formed over the substrate, one or more light emitting layers in an active region formed over the n-type layer or layers, and one or more p-type layers doped with, for example, Mg, formed over the active region. Electrical contacts are formed on the n- and p-type regions.

After the development of efficient III-nitride LEDs that emit blue light, it became practical to develop white light sources based on LEDs. White LEDs include one or more photo-luminescent materials such as phosphors, which absorb a portion of the radiation emitted by the LED and re-emit radiation of a different color (wavelength). Typically, the LED chip or die generates blue light and the phosphor(s) absorbs a percentage of the blue light and re-emits yellow light or a combination of green and red light, green and yellow light, or green and orange or yellow and red light. The portion of the blue light generated by the LED that is not absorbed by the phosphor combined with the light emitted by the phosphor provides light which appears to the human eye as being white in color.

This process of combining primary light emitted directly by the LED and secondary light emitted by the phosphor is also often applied to configurations where a plurality of LEDs share the same phosphor element. This may be done on a component level, where a plurality of blue LEDs are in direct contact with the phosphor, or on a module level, where a plurality of LEDs illuminate a single, remote phosphor element.

To maintain high color rendition, various phosphor materials are mixed on an LED or in a remote plate, or LEDs with red primary emitting color are introduced, to form a so-called "hybrid" system.

Fig. 1 illustrates an example of a hybrid lighting system, described in more detail in US 2012/0155076. The white light emitting system 40 of Fig. 4 includes a light emitting device 20 including blue-emitting LEDs 26 and red-emitting LEDs 28. The light emitting system 40 comprises at least one blue light excitable phosphor material 42 that is configured such that in operation the light emitting device 20 irradiates the phosphor material 42 with blue light 30. The phosphor material 42 absorbs a portion of the blue light 30 and in response emits light 44 of a different color typically yellow-green in color. The emission product 46 of the system 40 comprises the combined blue light 30 and red light 32 emitted by the LEDs 26, 28, and the light 44 generated by the phosphor material 42.

Solder pads 34, 36 are provided for providing electrical power to the blue and red LED chips. A driver 48 that is operable to control the forward drive currents i_{FB}, i_{FR} of the blue and red LEDs is electrically connected to the solder pads 34, 36. The driver 48 allows the blue and red LED chips to be controlled independently. The driver 48 can be operable in response to the measured intensities I_{B} and I_{R} of the blue and red light contributions in the emission product 46. By means of a feedback arrangement the driver 48 uses the measured intensities I_{B}, I_{R} to adjust the forward drive current i_{B}, i_{R} of the blue and/or red LED to compensate for changes arising in the color of the emission characteristics of the LEDs and/or phosphor material. The driver can alternatively and/or in addition be operable to control one/or both LED drive currents in response to the operating temperature T of the LEDs. DE102012101412 discloses the features of the preamble of the independent claim.

### Summary

It is an object of the invention to provide a lighting system with multiple LEDs which may have improved efficiency, improved flexibility, or improved performance.

A lighting system according to embodiments of the invention is defined in the appended claims.

### Brief description of the drawings

Fig. 1 illustrates a prior art hybrid lighting system.
Fig. 2 is a cross sectional view of a portion of a lighting system with at least three LEDs and a wavelength converting element spaced apart from the LEDs.
Fig. 3 is a cross sectional view of a portion of a lighting system with at least three LEDs and a wavelength converting element disposed over the LEDs.
Fig. 4 illustrates the absorption spectrum of the wavelength converting element and the peaks of emission spectra of two of the LEDs illustrated in Figs. 2 and 3.
Fig. 5 is a cross sectional view of a portion of a lighting system with at least three LEDs and a mixture of wavelength converting materials disposed over the LEDs.
Fig. 6 is a cross sectional view of a portion of a lighting system with at least three LEDs and multiple wavelength converting materials disposed over the LEDs in separate layers.
Fig. 7 is a cross sectional view of a portion of a lighting system with at least three LEDs and a mixture of wavelength converting materials disposed in a single layer that is spaced apart from the LEDs.
Fig. 8 is a cross sectional view of a portion of a lighting system with at least three LEDs and multiple wavelength converting materials spaced apart from the LEDs in separate layers.
Fig. 9 illustrates the absorption spectra of YAG:Ce and a Eu²⁺ red nitride phosphor.
Fig. 10 illustrates an arrangement of multiple LEDs in a lighting system.
Fig. 11 illustrates the absorption spectra of a Eu²⁺ green nitride phosphor and a KSiF:Mn⁴⁺ red phosphor, and the peak emission spectra of two blue LEDs.

### Detailed description

Embodiments of the invention are directed to lighting systems, including hybrid lighting systems, where the color temperature may be changed. Embodiments of the invention use the change in absorption strength of phosphor materials as a function of wavelength in a system with LEDs with different emission wavelengths, to create a light source with a tunable emission spectrum.

In the embodiments described below, the wavelength converting materials are referred to as phosphors for economy of language. It is to be understood that the wavelength converting material(s) may be any suitable material including, for example, conventional phosphors, organic phosphors, quantum dots, organic semiconductors, II-VI or III-V semiconductors, II-VI or III-V semiconductor quantum dots or nanocrystals, dyes, polymers, or other materials that luminesce.

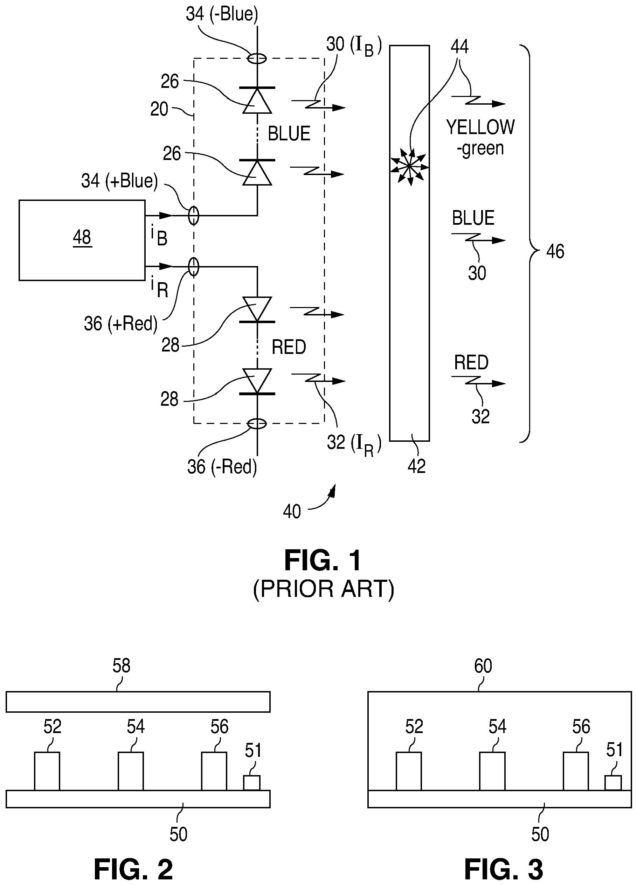

Figs. 2, 3, 5, 6, 7, and 8 are cross sectional views of portions of lighting systems where the color temperature of the emitted light may be altered.

In Figs. 2 and 3, the portions of the lighting systems illustrated include two blue LEDs and a red LED.

In each of Figs. 2 and 3, at least three LEDs 52, 54, and 56 are disposed on a substrate 50. LEDs 52 and 54 may both emit blue light. LEDs 52 and 54 have a different peak wavelength. The peak wavelengths of LEDs 52 and 54 may differ by at least 5 nm in some embodiments, at least 10 nm in some embodiments, at least 15 nm in some embodiments, no more than 40 nm in some embodiments, and no more than 30 nm in some embodiments. LEDs 52 and 54 may emit the desired wavelength of light directly, or they may be phosphor-converted LEDs. LED 56 may emit red light, either directly or via wavelength-conversion. LEDs 52, 54, and 56 may be any suitable, LEDs. LEDs 52, 54, and 56 may be attached to any suitable substrate 50 such as, for example, a metal core printed circuit board. The system may include a control circuit 51 for independently addressing LEDs 52, 54, and 56, and varying the amount of light produced by each of LEDs 52, 54, and 56.

In each of Figs. 2 and 3, a phosphor layer is positioned in the path of the light emitted by the three LEDs 52, 54, and 56. The phosphor layer may contain light scattering materials such as TiO₂ particles.

In Fig. 2, the phosphor layer 58 is a vicinity phosphor that is spaced apart from LEDs 52, 54, and 56. The vicinity phosphor layer 58 may be, for example, a luminescent ceramic, a phosphor mixed with a transparent binder that is dispensed, screen printed, stenciled, spin-casted, laminated, molded or otherwise formed on a transparent support substrate, or any other suitable structure.

In Fig. 3, the phosphor layer 60 is disposed over the LEDs 52, 54, and 56. The phosphor layer 60 may directly contact one or more of the LEDs 52, 54, and 56, though this is not required. The phosphor layer 60 may be, for example, a phosphor mixed with a transparent binder that is dispensed, screen printed, stenciled, spin-casted, laminated, molded or otherwise formed over LEDs 52, 54, and 56.

The light emitted by the lighting systems illustrated in Figs. 2 and 3 is a combination of blue light from LEDs 52 and/or 54, red light from LED 56, and light from the wavelength converting element 58, 60.

In embodiments, since LEDs 52 and 54 share the same wavelength converting element 58, 60, the color of the combined light may be tuned by selecting the peak wavelength of LEDs 52 and 54 and by selecting a phosphor with an appropriate absorption spectrum. In some embodiments, the phosphor in phosphor layers 58 and 60 is a yellow/green phosphor such as yttrium aluminum garnet doped with cerium, often abbreviated YAG:Ce.

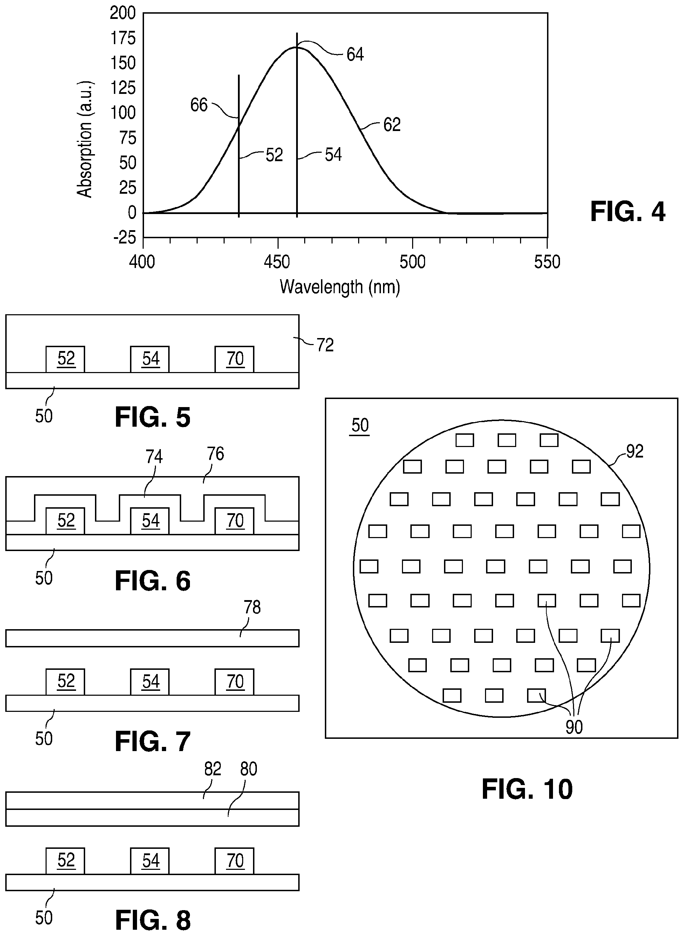

Fig. 4 illustrates a portion 62 of the absorption spectrum of YAG:Ce as a function of wavelength. Fig. 4 also illustrates the emission spectra of LEDs 52 and 54 in one embodiment. The emission of LED 52 is absorbed less by the wavelength converter than the emission of LED 54 (i.e., the y-axis value of point 66 on the absorption spectrum is less than the y-axis value of point 64). Accordingly, when LEDs 52 and 56 are activated and LED 54 is not activated, there is more blue light in the combined light and less green/yellow light in the combined light, as compared to when LEDs 54 and 56 are activated and LED 52 is not activated. The color temperature of the combined light can therefore be altered by activating one of LEDs 52 and 54, the other of LEDs 52 and 54, or both of LEDs 52 and 54.

In the embodiment illustrated in Fig. 4, LED 52 has a peak wavelength of 436 nm and LED 54 has a peak wavelength of 457 nm. The peak wavelength of LED 52 may be at least 426 nm in some embodiments, no more than 446 nm in some embodiments, at least 431 nm in some embodiments, and no more than 441 nm in some embodiments. The peak wavelength of LED 54 may be at least 447 nm in some embodiments, no more than 467 nm in some embodiments, at least 452 nm in some embodiments, and no more than 462 nm in some embodiments.

As illustrated in Figure 4, the primary light from LED 52 will not be absorbed and converted into secondary light by the wavelength converting layer as much as the light from LED 54. As a result, the combination of the primary light from LED 52 and secondary light from the wavelength converting layer will be of a different chromaticity than the primary light from LED 54 and secondary light from the same wavelength converting layer. The two different chromaticities can be combined with red light to produce light with different correlated color temperatures and high color rendering. Changing the ratio of light output from LEDs 52 and 54 and the red LED 56 allows continuous change (tuning) of the correlated color temperature (CCT) of the combined light.

In the structures illustrated in Figs. 2 and 3, light emitted by LED 56 is not absorbed by the wavelength converting elements 58, 60. Accordingly, though Figs. 2 and 3 illustrate LED 56 disposed beneath the wavelength converting elements, such that light emitted from LED 56 is incident on the wavelength converting elements, in some embodiments, LED 56 may be positioned outside the wavelength converting elements, such that light emitted from LED 56 is not incident on the wavelength converting elements.

In Figs. 5, 6, 7, and 8, the portions of the lighting systems illustrated include two blue LEDs and a UV LED.

In each of Figs. 5, 6, 7, and 8, at least three LEDs 52, 54, and 70 are disposed on a substrate 50. LEDs 52 and 54 may both emit blue light. LEDs 52 and 54 have a different peak wavelength. The peak wavelengths of LEDs 52 and 54 may differ by at least 5 nm in some embodiments, at least 10 nm in some embodiments, at least 15 nm in some embodiments, no more than 40 nm in some embodiments, and no more than 30 nm in some embodiments. LEDs 52 and 54 may emit the desired wavelength of light directly, or they may be phosphor-converted LEDs. LED 70 may emit UV light.

LEDs 52, 54, and 70 may be any suitable, LEDs. LEDs 52, 54, and 70 may be attached to any suitable substrate 50 such as, for example, a metal core printed circuit board. The system may include a control circuit (not shown) for independently addressing LEDs 52, 54, and 70 and for varying the light output of each of LEDs 52, 54, and 70.

In each of Figs. 5, 6, 7, and 8, a wavelength converting element is positioned in the path of the light emitted by the three LEDs 52, 54, and 70. The wavelength converting element includes two phosphors, one that is pumped by the blue LEDs 52 and 54 and emits yellow and/or green light, such as YAG:Ce, and one that is pumped by the UV LED 70 and emits red light. Either phosphor or both phosphors may be mixed with light scattering materials such as TiO₂ particles.

In Fig. 5, the two phosphors are mixed in a single layer 72 is disposed over the LEDs 52, 54, and 70. The phosphor layer 72 may directly contact one or more of the LEDs 52, 54, and 70, though this is not required. The phosphor layer 72 may be, for example, phosphors mixed with a transparent binder that is dispensed, screen printed, stenciled, spin-casted, laminated, molded or otherwise formed over LEDs 52, 54, and 70.

In Fig. 6, the two phosphors are disposed over the LEDs 52, 54, and 70 in two separate layers. A first phosphor layer 74 which may be, for example, the yellow/green emitting phosphor, is disposed over the LEDs. A second phosphor layer 76 which may be, for example, the red emitting phosphor, is disposed over the first phosphor layer 74. The order of the phosphor layers may be reversed, such that the red emitting phosphor is closest to the LEDs. The first phosphor layer 74 may directly contact one or more of the LEDs 52, 54, and 70, though this is not required. The first and second phosphor layers 74 and 76 may be, for example, phosphors mixed with transparent binders that are dispensed, screen printed, stenciled, spin-casted, laminated, molded or otherwise formed over LEDs 52, 54, and 70.

In Fig. 7, the two phosphors are mixed in a single layer 78 that is spaced apart from LEDs 52, 54, and 70. The phosphor layer 78 may be, for example, a luminescent ceramic, phosphors mixed with transparent binder that are dispensed, screen printed, stenciled, spin-casted, laminated, molded or otherwise formed on a transparent support substrate, or any other suitable structure.

In Fig. 8, the two phosphors are formed in separate layers that are spaced apart from LEDs 52, 54, and 70. A first phosphor layer 80 which may be, for example, the yellow/green emitting phosphor, is disposed closest to the LEDs. A second phosphor layer 82 which may be, for example, the red emitting phosphor, is disposed over the first phosphor layer 82. The order of the phosphor layers may be reversed, such that the red emitting phosphor is closest to the LEDs. One of the phosphor layers 80 and 82 may be, for example, a luminescent ceramic, a phosphor mixed with a transparent binder that is dispensed, screen printed, stenciled, spin-casted, laminated, molded or otherwise formed on a transparent support substrate, or any other suitable structure. The other phosphor layer may be attached to the first phosphor layer and may be any type of phosphor layer formed by any technique described herein. In one example, a red powder phosphor is mixed with a transparent binder material and dispensed on a yellow/green emitting YAG ceramic slab.

The light emitted by the lighting systems illustrated in Figs. 5, 6, 7, and 8 is a combination of blue light from LEDs 52 and/or 54, red light from the red emitting phosphor, and yellow/green light from yellow/green emitting phosphor. A filter (not shown) may be included in the structure. For example, a filter to reflect or absorb UV and/or blue light, to prevent UV and/or blue light from escaping the structure, may be formed over the red emitting phosphor. A filter to reflect unconverted UV or blue light back through the red emitting phosphor so that it may be converted by the red emitting phosphor, may be formed over the red emitting phosphor. The filter may reflect or absorb all or only a portion of the UV and/or blue light. In the alternative the filter, which may be a UV or blue filter, may cover a combined phosphor.

The color of the combined light may be tuned by selecting the peak wavelength of LEDs 52 and 54 and by selecting a green/yellow phosphor with an appropriate absorption spectrum. In some embodiments, the green/yellow phosphor is YAG:Ce. Though in the examples discussed below, the green/yellow phosphor is YAG, any suitable green/yellow phosphor may be used, including other garnet phosphors The wavelength of UV LED 70 may be selected such that no light or very little light from UV LED 70 is absorbed by the green/yellow phosphor.

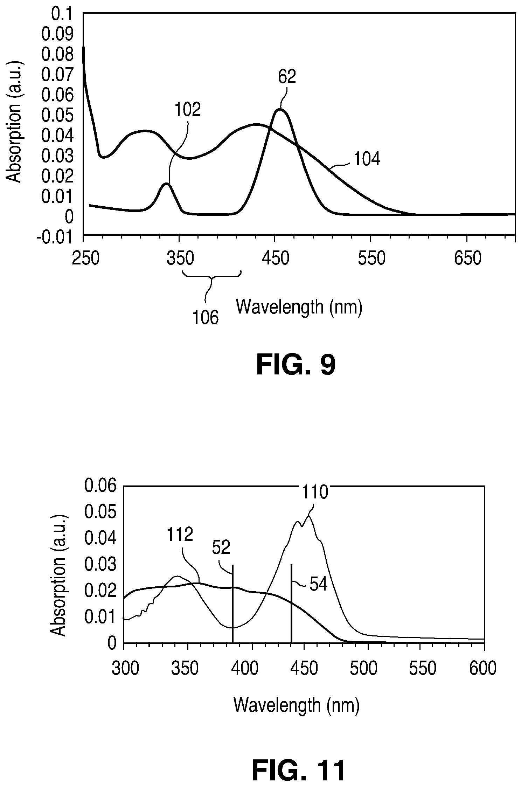

Fig. 9 illustrates the absorption spectra of YAG:Ce and a red phosphor, as a function of wavelength. The absorption spectrum of YAG:Ce includes two peaks, peak 62, which is illustrated in Fig. 4, and peak 102, which is in the UV range. In the devices illustrated in Figs. 5, 6, 7, and 8, the peak wavelength of LEDs 52 and 54 may be in the wavelength range of peak 62, as described above in reference to Fig. 4. As described in reference to Fig. 4, when LEDs 52 and 70 are activated and LED 54 is not activated, there is more blue light in the combined light and less green/yellow light in the combined light, as compared to when LEDs 54 and 70 are activated and LED 52 is not activated. The color temperature of the combined light can therefore be altered by activating one of LEDs 52 and 54, the other of LEDs 52 and 54, or both of LEDs 52 and 54.

In some embodiments, the peak emission wavelength of UV LED 70 is selected to be in the range 106, between the peaks 102 and 62 in the YAG:Ce absorption spectrum. UV light in wavelength range 106 will not be significantly absorbed by the yellow/green YAG:Ce phosphor in any significant quantity. UV light in wavelength range 106 is absorbed by the red phosphor, as illustrated by the absorption spectrum 104 of the red phosphor. Any suitable red emitting phosphor may be used. Examples of suitable materials include Eu²⁺ activated nitride red emitting materials such as MₓSi_{y}N_{z}:Eu, wherein M is at least one of an alkaline earth metal chosen from the group Ca, Sr, Ba, Zn and wherein z = 2/3x+4/3y; (Ca_{1-z}-_{y-z}SrₓBa_{y}Mg_{z})₁₋ₙ(Al_{1-a+b}Ba)Si_{1-b}N_{3-b}O_{b}:REₙ, wherein 0 ≤ x ≤ 1, 0 ≤ y ≤ 1, 0 ≤ z ≤ 1, 0 ≤ a ≤ 1, 0 < b ≤ 1 and 0.002 ≤ n ≤ 0.2, and RE is selected from europium(II) and cerium(III); and Eu²⁺ activated sulfide red emitting materials such as CaSeS:Eu and (Ca,Sr)S:Eu.

In Fig. 9, LED 52 has a peak wavelength of 436 nm and LED 54 has a peak wavelength of 457 nm. The peak wavelength of LED 52 may be at least 426 nm in some embodiments, no more than 446 nm in some embodiments, at least 431 nm in some embodiments, and no more than 441 nm in some embodiments. The peak wavelength of LED 54 may be at least 447 nm in some embodiments, no more than 467 nm in some embodiments, at least 452 nm in some embodiments, and no more than 462 nm in some embodiments. The peak wavelength of LED 70 may be at least 355 in some embodiments, no more than 410 nm in some embodiments, at least 370 in some embodiments, and no more than 400 in some embodiments. As described above in reference to Fig. 4, the CCT of the combined light from the blue LEDs, the yellow/green emitting phosphor, and the red emitting phosphor may be tuned by varying the output from each of LEDs 52, 54, and 70.

In some embodiments, a separate red light source (such as red LEDs 56 in Figs. 2 and 3, and UV LEDs 70 in Figs. 5, 6, 7, and 8) is omitted and red light is generated by phosphor conversion of one or both of blue LEDs 52, 54. Fig. 11 illustrates the absorption spectra of red and green phosphors that may be used in such an embodiment. Spectrum 112 is the absorption spectrum of a green emitting Eu²⁺-activated nitride phosphor, such as SSON, beta Sialon, or orthosilicate. Spectrum 110 is the absorption spectrum of a red emitting Mn⁴⁺-activated hexaflouorosilicate phosphor, such as KSiF:Mn⁴⁺. Lines 52 and 54 illustrate the peak emission wavelength of blue LEDs 52 and 54. As illustrated in Fig. 11, the green emitting phosphor 112 absorbs light from both LEDs 52 and 54. The red emitting phosphor 110 absorbs light from LED 54 strongly, but absorbs very little or no light from LED 52. For example, the absorption of the red phosphor at the peak wavelength of LED 54 may be at least twice the absorption of the red phosphor at the peak wavelength of LED 52 in some embodiments, at least three times the absorption of the red phosphor at the peak wavelength of LED 52 in some embodiments, and at least four times the absorption of the red phosphor at the peak wavelength of LED 52 in some embodiments. The peak wavelength of LED 52 may be at least 370 nm in some embodiments and no more than 405 in some embodiments. The peak wavelength of LED 54 may be at least 430 nm in some embodiments and no more than 450 in some embodiments. The amount of green light and blue light in the combined light can be varied by varying the output of LED 52. As described above in reference to Fig. 4, the CCT of the combined light from the blue LEDs, the yellow/green emitting phosphor, and the red emitting phosphor may be tuned by varying the output from LEDs 52 and 54.

In some embodiments, the color rendering index of the lighting systems described herein is maintained above 80. The color rendering index may be tuned by appropriately selecting the emission spectra of the LEDs and the phosphors.

The absorption spectrum of YAG:Ce may be manipulated by adding one or more of gadolinium, lutetium, gallium, tellurium to the garnet matrix of the phosphor, as is known in the art.

Fig. 10 illustrates the placement of LEDs in one example of a device incorporating one or more of the partial structures illustrated in Figs. 2, 3, 5, 6, 7, and 8. The outline of the wavelength converting element is illustrated by circle 92. Multiple LEDs 90 are disposed beneath the wavelength converting element 92. More or fewer LEDs 90 may be used than are illustrated in Fig. 10. The LEDs 90 may be attached to a support 50 which may be, for example, a wiring substrate, circuit board, or any other suitable structure. Control circuitry, not shown in Fig. 10, may be electrically connected to LEDs 90 via the support 50.

LEDs 90 include blue LEDs 52 and 54 and red LEDs 56 and/or UV LEDs 70, for generating red light as described above. The LEDs 90 may be evenly divided between blue LED 52, blue LED 54, and red or UV LED 56, 70 in some embodiments. In some embodiments, there are more blue LEDs 52 and 54 than red light sources 56, 70. For example, the ratio of blue LEDs 52, 54 to red light sources 56, 70 may be at least 3:1 in some embodiments, at least 4:1 in some embodiments, and no more than 8:1 in some embodiments. The blue LEDs may be evenly divided between LEDs 52 and LEDs 54 in some embodiments. There may be more LEDs 52 than LEDs 54 in some embodiments. There may be more LEDs 54 than LEDs 52 in some embodiments.

Though in the examples below the semiconductor light emitting device are III-nitride LEDs that emits blue or UV light, semiconductor light emitting devices besides LEDs such as laser diodes and semiconductor light emitting devices made from other materials systems such as other III-V materials, III-phosphide, III-arsenide, II-VI materials, ZnO, or Si-based materials may be used.

## Claims

1. A lighting system comprising: first and second light emitting diodes (52, 54), wherein the first and second light emitting diodes have different peak wavelengths and emit light of the same color; a third light emitting diode (70) that emits light of a different color from the first and second light emitting diodes; and a wavelength converting element (72, 74, 76, 78, 80, 82) disposed in a path of light emitted by the first, second and third light emitting diodes; **characterised in that** the third light emitting diode (70) emits ultraviolet (UV) light and a portion of the wavelength converting element is disposed in a path of light emitted by the third light emitting diode (70) absorbing UV light and emitting red light.

2. The lighting system of claim 1 wherein the peak wavelengths of the first and second light emitting diodes differ by at least 10 nm.

3. The lighting system of claim 1 wherein the wavelength converting element comprises a phosphor, the phosphor having different absorption at the peak wavelengths of the first and second light emitting diodes.

4. The lighting system of claim 1 wherein:
the wavelength converting element comprises a first phosphor and a second phosphor; and
the first phosphor and the second phosphor emit different colors of light.

5. The lighting system of claim 4 wherein the first phosphor absorbs UV light and emits red light.

6. The lighting system of claim 5 wherein the second phosphor does not emit light in response to light emitted by the third light emitting diode.

7. The lighting system of claim 4 wherein the first and second phosphors are mixed in a single layer.

8. The lighting system of claim 4 wherein the first and second phosphors are disposed in separate layers.

9. The lighting system of claim 1 wherein:
the first light emitting diode emits light with a peak wavelength between 431 and 441 nm;
the second light emitting diode emits light with a peak wavelength between 452 nm and 462 nm; and
the wavelength converting element comprises YAG:Ce.

10. The lighting system of claim 1 further comprising a control circuit for activating the first and third light emitting diodes simultaneously without activating the second light emitting diode, and for activating the second and third light emitting diodes simultaneously without activating the first light emitting diode.

11. The lighting system of claim 1 wherein the first and second light emitting diodes emit blue light.

12. The lighting system of claim 1 further comprising a filter to reflect or absorb a portion of light emitted by the third light emitting diode, wherein the wavelength converting element is disposed between the filter and the third light emitting diode.

13. The lighting system of claim 1 wherein the wavelength converting element is spaced apart from the first, second and third light emitting diodes.

14. The lighting system of claim 13 wherein the peak wavelengths of the first and second light emitting diodes differ by at least 10 nm.

15. The lighting system of claim 13 wherein: the wavelength converting element comprises a first phosphor and a second phosphor; the first phosphor and the second phosphor emit different colors of light.

## Patentansprüche

1. Beleuchtungssystem, umfassend: erste und zweite Leuchtdioden (52, 54), wobei die ersten und zweiten Leuchtdioden verschiedene Spitzenwellenlängen aufweisen und Licht der gleichen Farbe emittieren; eine dritte Leuchtdiode (70), die Licht einer von der ersten und der zweiten Leuchtdiode verschiedenen Farbe emittiert; und ein Wellenlängenumwandlungselement (72, 74, 76, 78, 80, 82), das in einem Pfad von Licht angeordnet ist, das durch die erste, die zweite und die dritte Leuchtdiode emittiert wird; **dadurch gekennzeichnet, dass** die dritte Leuchtdiode (70) Ultraviolett (UV)-Licht emittiert und ein Abschnitt des Wellenlängenumwandlungselements in einem Pfad von Licht, das durch die dritte Leuchtdiode (70) emittiert wird, angeordnet ist und UV-Licht absorbiert und rotes Licht emittiert.

2. Beleuchtungssystem nach Anspruch 1, wobei die Spitzenwellenlängen der ersten und der zweiten Leuchtdiode sich um mindestens 10 nm unterscheiden.

3. Beleuchtungssystem nach Anspruch 1, wobei das Wellenlängenumwandlungselement einen Phosphor umfasst, wobei der Phosphor unterschiedliche Absorption bei den Spitzenwellenlängen der ersten und der zweiten Leuchtdiode aufweist.

4. Beleuchtungssystem nach Anspruch 1, wobei:
das Wellenlängenumwandlungselement einen ersten Phosphor und einen zweiten Phosphor umfasst; und
der erste Phosphor und der zweite Phosphor verschiedene Farben von Licht emittieren.

5. Beleuchtungssystem nach Anspruch 4, wobei der erste Phosphor UV-Licht absorbiert und rotes Licht emittiert.

6. Beleuchtungssystem nach Anspruch 5, wobei der zweite Phosphor kein Licht in Reaktion auf Licht emittiert, das durch die dritte Leuchtdiode emittiert wird.

7. Beleuchtungssystem nach Anspruch 4, wobei der erste und der zweite Phosphor in einer einzigen Schicht vermischt sind.

8. Beleuchtungssystem nach Anspruch 4, wobei der erste und der zweite Phosphor in getrennten Schichten angeordnet sind.

9. Beleuchtungssystem nach Anspruch 1, wobei:
die erste Leuchtdiode Licht mit einer Spitzenwellenlänge zwischen 431 und 441 nm emittiert;
die erste Leuchtdiode Licht mit einer Spitzenwellenlänge zwischen 452 nm und 462 nm emittiert; und
das Wellenlängenumwandlungselement YAG:Ce umfasst.

10. Beleuchtungssystem nach Anspruch 1, ferner umfassend eine Steuerschaltung zum gleichzeitigen Aktivieren der ersten und der dritten Leuchtdiode ohne Aktivieren der zweiten Leuchtdiode und zum gleichzeitigen Aktivieren der zweiten und der dritten Leuchtdiode ohne Aktivieren der ersten Leuchtdiode.

11. Beleuchtungssystem nach Anspruch 1, wobei die erste und die zweite Leuchtdiode blaues Licht emittieren.

12. Beleuchtungssystem nach Anspruch 1, ferner umfassend ein Filter zum Reflektieren oder Absorbieren eines Teils von Licht, das durch die dritte Leuchtdiode emittiert wird, wobei das Wellenlängenumwandlungselement zwischen dem Filter und der dritten Leuchtdiode angeordnet ist.

13. Beleuchtungssystem nach Anspruch 1, wobei das Wellenlängenelement von der ersten, der zweiten und der dritten Leuchtdiode beabstandet ist.

14. Beleuchtungssystem nach Anspruch 13, wobei die Spitzenwellenlängen der ersten und der zweiten Leuchtdiode sich um mindestens 10 nm unterscheiden.

15. Beleuchtungssystem nach Anspruch 13, wobei das Wellenlängenumwandlungselement einen ersten Phosphor und einen zweiten Phosphor umfasst; wobei der erste Phosphor und der zweite Phosphor verschiedene Farben von Licht emittieren.

## Revendications

1. Système d'éclairage comprenant : une première et une seconde diodes électroluminescentes (52, 54), dans lequel la première et la seconde diodes électroluminescentes possèdent des longueurs d'onde maximales différentes et émettent une lumière de la même couleur ; une troisième diode électroluminescente (70) qui émet une lumière d'une couleur différente de la première et de la seconde diodes électroluminescentes ; et un élément de conversion de longueur d'onde (72, 74, 76, 78, 80, 82) disposé sur un trajet de la lumière émise par la première, la seconde et la troisième diodes électroluminescentes ; **caractérisé en ce que** la troisième diode électroluminescente (70) émet une lumière ultraviolette (UV) et une partie de l'élément de conversion de longueur d'onde est disposée sur un trajet de la lumière émise par la troisième diode électroluminescente (70) qui absorbe la lumière UV et la lumière rouge d'émission.

2. Système d'éclairage selon la revendication 1, dans lequel les longueurs d'onde maximales de la première et de la seconde diodes électroluminescentes diffèrent d'au moins 10 nm.

3. Système d'éclairage selon la revendication 1, dans lequel l'élément de conversion de longueur d'onde comprend un phosphore, le phosphore ayant une absorption différente aux longueurs d'onde maximales de la première et de la seconde diodes électroluminescentes.

4. Système d'éclairage selon la revendication 1, dans lequel :
l'élément de conversion de longueur d'onde comprend un premier phosphore et un second phosphore ;
et
le premier phosphore et le second phosphore émettent des couleurs de lumière différentes.

5. Système d'éclairage selon la revendication 4, dans lequel le premier phosphore absorbe la lumière UV et émet une lumière rouge.

6. Système d'éclairage selon la revendication 5, dans lequel le second phosphore n'émet pas de lumière en réponse à la lumière émise par la troisième diode électroluminescente.

7. Système d'éclairage selon la revendication 4, dans lequel le premier et le second phosphores sont mélangés en une seule couche.

8. Système d'éclairage selon la revendication 4, dans lequel le premier et le second phosphores sont disposés en couches distinctes.

9. Système d'éclairage selon la revendication 1, dans lequel :
la première diode électroluminescente émet une lumière ayant une longueur d'onde maximale comprise entre 431 et 441 nm ;
la seconde diode électroluminescente émet une lumière ayant une longueur d'onde maximale comprise entre 452 nm et 462 nm ; et
l'élément de conversion de longueur d'onde comprend du YAG:Ce.

10. Système d'éclairage selon la revendication 1, comprenant en outre un circuit de commande destiné à activer la première et la troisième diodes électroluminescentes en même temps sans activer la seconde diode électroluminescente, et à activer la seconde et la troisième diodes électroluminescentes en même temps sans activer la première diode électroluminescente.

11. Système d'éclairage selon la revendication 1, dans lequel la première et la seconde diodes électroluminescentes émettent une lumière bleue.

12. Système d'éclairage selon la revendication 1, comprenant en outre un filtre destiné à réfléchir ou à absorber une partie de la lumière émise par la troisième diode électroluminescente, dans lequel l'élément de conversion de longueur d'onde est disposé entre le filtre et la troisième diode électroluminescente.

13. Système d'éclairage selon la revendication 1, dans lequel l'élément de conversion de longueur d'onde est espacé de la première, de la seconde et de la troisième diodes électroluminescentes.

14. Système d'éclairage selon la revendication 13, dans lequel les longueurs d'onde maximales de la première et de la seconde diodes électroluminescentes diffèrent d'au moins 10 nm.

15. Système d'éclairage selon la revendication 13, dans lequel : l'élément de conversion de longueur d'onde comprend un premier phosphore et un second phosphore ; le premier phosphore et le second phosphore émettent des couleurs de lumière différentes.
